(19) **Europäisches Patentamt**
**European Patent Office**
**Office européen des brevets**

(11) **EP 1 287 373 B1**

(12) **EUROPÄISCHE PATENTSCHRIFT**

(45) Veröffentlichungstag und Bekanntmachung des Hinweises auf die Patenterteilung:
**14.05.2008 Patentblatt 2008/20**

(21) Anmeldenummer: **01943120.4**

(22) Anmeldetag: **19.05.2001**

(51) Int Cl.:
**G01R 33/50** (2006.01)

(86) Internationale Anmeldenummer:
**PCT/DE2001/001923**

(87) Internationale Veröffentlichungsnummer:
**WO 2001/094965 (13.12.2001 Gazette 2001/50)**

(54) **PULSFOLGE, KERNSPINRESONANZTOMOGRAPH UND BILDGEBUNGSVERFAHREN**

PULSE TRAIN, NUCLEAR MAGNETIC RESONANCE TOMOGRAPH AND IMAGING METHOD

TRAIN D'IMPULSIONS, TOMOGRAPHE A RESONANCE MAGNETIQUE NUCLEAIRE ET PROCEDE D'IMAGERIE

(84) Benannte Vertragsstaaten:
**AT BE CH CY DE DK ES FI FR GB GR IE IT LI LU MC NL PT SE TR**

(30) Priorität: **09.06.2000 DE 10028171**

(43) Veröffentlichungstag der Anmeldung:
**05.03.2003 Patentblatt 2003/10**

(73) Patentinhaber: **Forschungszentrum Jülich GmbH 52425 Jülich (DE)**

(72) Erfinder:
• **SHAH, Nadim, Joni 52428 Jülich (DE)**

• **STEINHOFF, Sven 52078 Aachen (DE)**
• **ZAITSEV, Maxim 79117 Freiburg (DE)**

(56) Entgegenhaltungen:
**EP-A- 0 357 100          WO-A-93/01509
US-A- 4 757 260**

• **K. OSHIO, D.A. FEINBERG: "Single-Shot GRASE Imaging without Fast Gradients" MAGNETIC RESONANCE IN MEDICINE, Bd. 26, 1992, Seiten 355-360, XP000294183**

**Beschreibung**

Die Erfindung betrifft eine Pulsfolge nach dem Oberbegriff des Anspruchs 1, einen Kernspinresonanztomographen sowie ein Bildgebungsverfahren.

Bereits seit die Methode der Magnetresonanz - Bildgebungsmethoden (MRI) - erfunden wurde, wurde erwartet, daß diese Methode mehr als nur einfache qualitative Bildgebung ermöglicht und auch geeignet ist, quantitative Bildgebung zu erzeugen. MRI ist einerseits eine ausgereifte Methode, die täglich in der klinischen Bildgebung Anwendung für einfache qualitative bildliche Darstellungen findet. Andererseits ist MRI ein sehr wichtiges Instrument, in der Industrie und Wissenschaft mit den unterschiedlichsten Anwendungesgebieten, wie Qualitätskontrolle, vorklinische Bewertung von Drogen in der pharmazeutischen Industrie und Bestimmung von Porengrößen in Gesteinsproben der petrochemischen Industrie. Für Gesteinsproben wird eine quantitative Bildgebung benötigt und auch erstellt. Die MRI-Signale werden durch sinnvolle und kontrollierte Manipulation entsprechender Meßparameter, wie Pulssequenzen, empfindlicher gemacht oder gewichtet, um den Einfluß ausgesuchter Parameter zu zeigen. Im Allgemeinen ist es bei der Erfassung einer Serie von unterschiedlich gewichteten Bildern und bei Gebrauch geeigneter Modelle möglich, quantitative Darstellungen der ausgewählten Parameter zu erzeugen. Auf diesem Weg können quantitative Bilder von Proben erzeugt werden, um den lokalen Wert eines bestimmten Parameters, wie Diffusion, Protonendichte oder Spin-Gitter-Relaxationszeit zu bestimmen.

Der Begriff "Probe" ist im vorliegenden Fall in seiner weitesten Bedeutung gemeint und umfaßt lebendes und nicht lebendes Material.

Es sind verschiedene Verfahren bekannt, bei denen eine Probe mittels eines Anregungspulses und mehrerer Rephasierungspulse untersucht wird.

Bei dem gattungsgemäßen Verfahren wird die Probe durch elektromagnetische Strahlung mit einer zu einer Anregung geeigneten Energie angeregt.

In der Kernmagnetresonanztomographie ist es bekannt, durch eine Anregung von Echosignalen einer Probe Informationen über die Probe zu erhalten.

Bei der Kernresonanztomographie werden Atomkerne, welche ein magnetisches Moment besitzen, durch ein extern angelegtes Magnetfeld ausgerichtet. Dabei führen die Kerne um die Richtung des Magnetfeldes eine Präzessions-Bewegung mit einer charakteristischen Kreisfrequenz (Larmor-Frequenz) aus. Die Larmor-Frequenz hängt von der Stärke des magnetischen Feldes und von den magnetischen Eigenschaften der Substanz ab, insbesondere der gyromagnetischen Konstante $\gamma$ des Kerns. Die gyromagnetische Konstante $\gamma$ ist eine für jede Atomart charakteristische Größe. Die Atomkerne weisen ein magnetisches Moment $\mu = \gamma \times p$ auf, wobei p den Drehimpuls des Kerns bezeichnet.

Eine zu untersuchende Substanz, beziehungsweise eine zu untersuchende Person, werden bei der Kernresonanztomographie einem gleichförmigen Magnetfeld unterworfen. Das gleichförmige Magnetfeld wird auch als Polarisationsfeld $B_o$ und die Achse des gleichförmigen Magnetfeldes als z-Achse bezeichnet. Die individuellen magnetischen Momente der Spins in dem Gewebe präzedieren mit ihrer charakteristischen Larmor-Frequenz um die Achse des gleichförmigen Magnetfeldes.

Eine Nettomagnetisierung $M_z$ wird in der Richtung des Polarisationsfeldes erzeugt, wobei sich die zufällig orientierten Magnetkomponenten in der Ebene senkrecht hierzu (x-y-Ebene) einander aufheben. Nach Anlegen des gleichförmigen Magnetfeldes wird zusätzlich ein Anregungsfeld $B_1$ erzeugt. Das Anregungsfeld $B_1$ ist in der x-y-Ebene polarisiert und weist eine Frequenz auf, die möglichst nahe an der Larmor-Frequenz liegt. Hierdurch kann das Nettomagnetmoment $M_z$ in die x-y-Ebene gekippt werden, so daß eine quermagnetische Magnetisierung $M_t$ entsteht. Die Querkomponente der Magnetisierung rotiert in der x-y-Ebene mit der Larmor-Frequenz.

Durch eine zeitliche Variation des Anregungsfeldes können verschiedene zeitliche Abfolgen der quermagnetischen Magnetisierung $M_t$ erzeugt werden. In Verbindung mit wenigstens einem angelegten Gradientenfeld können verschiedene Schichtprofile realisiert werden.

Durch NMR-Bildgebungsmethoden werden Schichten oder Volumina selektiert, die unter dem geeigneten Einstrahlen von Hochfrequenzimpulsen und dem Anlegen von magnetischen Gradientenfeldern ein Meßsignal liefern, welches digitalisiert und als ein ein- oder mehrdimensionales Feld im Meßcomputer gespeichert wird.

Dieses mehrdimensionale Feld, welches sich durch die Messung ergibt, kann auch in einem Orts-Frequenzraum dargestellt werden, dem k-Raum. Die Koordinaten dieses Orts-Frequenzraumes ergeben sich aus $\underline{k} = -\gamma \int \underline{G} \, dt$. Der äußere Bereich des k-Raums definiert die Strukturen des rekonstruierten Bildes, während der innere Bereich den Kontrast bestimmt.

Aus den aufgenommenen Rohdaten wird durch eine ein- oder mehrdimensionale Fourier-Transformation die gewünschte Bildinformation gewonnen (rekonstruiert). Zuvor kann es sein, daß die Meßdaten des mehrdimensionalen Datenfeldes so im Datenspeicher angeordnet werden müssen, daß sich die jeweiligen k-Räume der entsprechenden Schichten ergeben. Hierfür werden Umsortierungsprozeduren implementiert.

Ein rekonstruiertes Schichtbild besteht aus Pixeln, ein Volumendatensatz aus Voxeln. Ein Pixel (Picture Element) ist ein zweidimensionales Bildelement, beispielsweise ein Quadrat. Das Bild ist aus den Pixeln zusammengesetzt.

Ein Voxel (Volume Pixel) ist ein dreidimensionales Volumenelement, beispielsweise ein Quader. Die Abmessungen eines Pixels liegen in der Größenordnung von 1 mm$^2$, die eines Voxels von 1 mm$^3$. Die Geometrien und Ausdehnungen können variabel sein.

Da aus experimentellen Gründen bei Schichtbildern niemals von einer streng zweidimensionalen Ebene ausgegangen werden kann, wird häufig auch hier der Begriff Voxel verwendet, welcher besagt, daß die Bildebenen eine Dicke haben.

Der Darstellung der Spin-Gitter-Relaxationszeit, $T_1$, wurde wenig Aufmerksamkeit geschenkt, da die meisten in der Literatur dargestellten Methoden lange Erfassungszeiten benötigen, die diese Methoden für routinemäßige klinische Untersuchungen unbrauchbar machen.

Der Vorteil, der raschen Datenakquisition, der durch die schnelle "Inversion-Recovery (Inversion - Relaxations) EPI (Echo-Planare Bildgebung) Methode" von R.J. Ordidge et al. Magnetic Resonance in Medicine 16, 238-245 (1990) , erzielt wurde, kam dadurch nicht zum Tragen, daß EPI keine weit verbreitete Methode ist. So haben mit dieser Methode verbundene inherente Artefakte den Gebrauch dieser andererseits eleganten Methode verhindert. Das gilt insbesondere dort, wo Bildgebung höchster Qualität benötigt wird, wie für die Segmentierung des menschlichen Gehirns. Andere quantitative Bildgebungsmethoden (Deichmann et al., Journal of Magnetic Resonance, 96, 608-612 (1992); Blüml et. al., MRM 30, 289-295 (1993); Deichmann et. al., Magnetic Resonance in Medicine, 42:206-209 (1999) ), sind langsamer als IR-EPI und nicht schnell genug um praktische Bedeutung zu erlangen. Die beiden Annäherungen basieren hauptsächlich auf der spektroskopischen Look-Locker-Methode Look DC und Locker DR (The Review of Scientific Instruments, Vol.41 Nr.2, 250-251, (1970) ), die aufeinanderfolgende Anregungspulse während einer longitudinalen Relaxation ausnutzt, um somit zahlreiche Zeit-Punkte während der Relaxation zu sammeln. So kann ein effektiveres Zeit-Darstellungs-Schema erstellt werden, das Bewegungsartefakte unterbindet.

Die original "snapshot FLASH" - Methode von Deichmann et. Al., Journal of Magnetic Resonance, 96, 608-612 (1992), benötigt hohe Erfassungszeiten, da die Ausgangsmagnetisierung wieder voll hergestellt werden muss. Im Falle hoher räumlicher Auflösung wird zusätzlich die zeitliche Auflösung deutlich beschränkt. Dieses kommt speziell bei Kernspintomographen ohne Hochleistungsgradientensysteme zum Tragen.

Die EP 0 357 100 A2 offenbart ein Kernspintomographieverfahren, bei dem zwei schichtselektive Hochfrequenzimpulse die Kernmagnetisierung in einer Schicht beeinflussen.

Die WO 93/01509 beschreibt ein NMR-Verfahren und eine Vorrichtung bei denen in jedem Wiederholungsintervall nach einem Eingangs applizierten 90°RF-Puls eine Sequenz von 180°RF-Pulsen zur Refokussierung des RF-Signals in korrespondierende Zeile von Spin-Echos führt.

Bei der kernresonanzmagnetischen Vermessung des Gehirns, insbesondere des menschlichen Gehirns, besteht der Bedarf, über das gesamte Hirnvolumen Messpunkte zu erlangen, welche zu einer höchstmöglichen Auflösung eines Schichtbildes führen und möglichst viele Schichtbilder in einem kurzen Zeitraum generieren. Das Erfordernis besteht insbesondere dann, wenn kranke und schwer verletzte Menschen schnell diagnostiziert werden sollen. Die nach dem Stand der Technik bekannten Verfahren benötigen eine sehr lange Erfassungszeit von > 1 Stunde und sind für den klinischen Betrieb unbrauchbar. Die Methoden, die auf "snapshot-FLASH" basieren, sind schneller. Da es sich jedoch um Ein-Schicht-Methoden handelt, ist keine hohe räumliche Auflösung zu erzielen. Auf EPI basierende Methoden sind sehr schnell, aber haben eine Vielzahl von Nachteilen, die eine Folge der zwangsweisen Natur der Methoden sind. Diese Artefakte schließen Geisterbilder in Folge von Phasenfehlern und zeitweise starke geometrische Störungen ein.

Es ist daher die Aufgabe der Erfindung, ein Bildgebungsverfahren, einen Kernresonanztomographen und eine Pulsfolge zu schaffen, welche in möglichst kurzer Meßzeit ein Schichtbild oder eine Abfolge von Schichtbildern des Gehirns in höchster Auflösung generiert.

Ausgehend vom Oberbegriff des Anspruchs 1 wird die Aufgabe erfindungsgemäß gelöst mit den in kennzeichnenden Teil des Anspruchs 1 angegebenen Merkmalen.

Das erfindungsgemäße Bildgebungsverfahren ermöglicht die Akquisition von 20 Schichten zu 16 unterschiedlichen Zeitpunkten für eine Matrixgröße von 256 x 256 in einer Meßzeit von 8 min 28 sec.

Vorteilhafte Weiterbildungen der Erfindung sind in den Unteransprüchen angegeben.

Die Figuren zeigen verschiedene Versuchsergebnisse und Parameter.

Es zeigt:

Fig.1: Ein Abtastschema der erfindungsgemäßen Pulssequenz

Fig.2a,b: Eine erfindungsgemäße Pulssequenz

Fig.3: Darstellung der erhaltenen Echos im k-Raum

Fig.4: Rekonstruierte Relaxationskarte eines Phantoms.

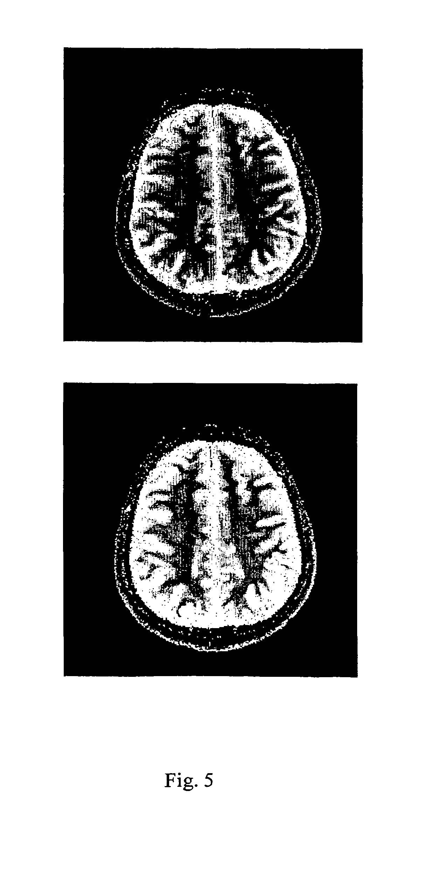

Fig.5:       Quantitative in vivo T1 Karten eines Querschnittes durch das menschliche Gehirn.

Im folgenden soll die Erfindung beispielhaft erläutert werden.

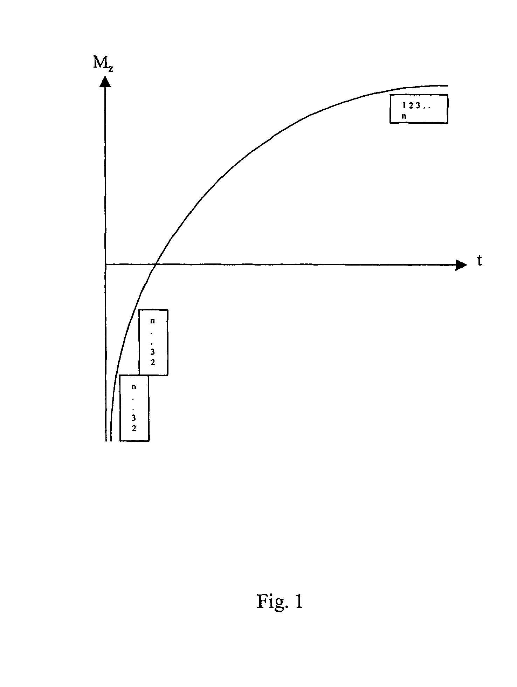

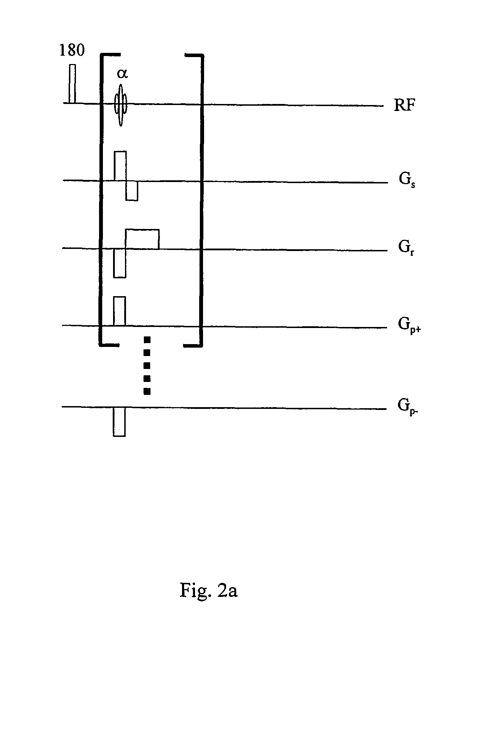

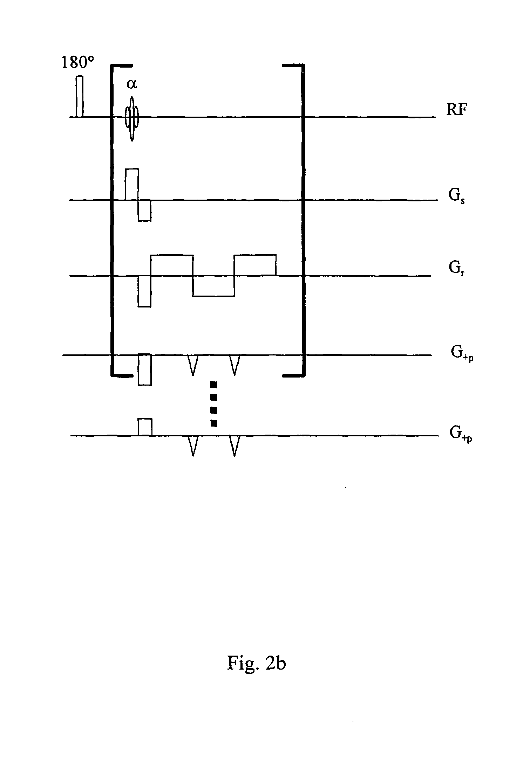

Bei der Durchführung des erfindungsgemäßen Verfahrens zur Bestimmung der longitudinalen Relaxationskonstanten $T_1$ wird die Probe, zum Beispiel der Schädel des zu untersuchenden Patienten, in die Spule eines Kernmagnetresonanztomographen eingeführt. Die Probe liegt im Zentrum des homogenen, statischen Grundmagnetfeldes $B_0$. Die räumliche Auflösung erfolgt mit Hilfe von zeitlich veränderlichen Magnetfeldern (Gradienten). Diese sind bauartbedingt in einem kartesischen Koordinatensystem angeordnet. Zur Datengewinnung ist es notwendig, ein hochfrequentes Anregungsfeld zu schalten. Die Anregungsfrequenz ist zum einen vom statischen Grundfeld, zum anderen von der Kernart der untersuchten Probe abhängig. Nach erfolgter Anregung mit einem nicht schichtselektiven (oder volumenselektiven) 180°-Puls oder wahlweise einem 90°-Puls, gefolgt von einem 180°-Puls - beide nicht schichtselektiv oder beide volumenselektiv - , werden die Daten in zwei voneinander unterschiedlichen Abläufen akquiriert. Nach dem 180°-Puls muß die transversale Magnetisierung $M_{xy}$ null sein (z.B. infolge Gradientenspoiling). Für beide Fälle wird zur Datengewinnung ein Hf-Puls ($\alpha$) angelegt, kombiniert mit Gradientenfolgen zur Erzeugung mindestens eines k-Raum kodierten Echo's. Dieses Meßschema (Hf-Pulse ($\alpha$) und Gradientenfolge) sei im folgenden Akquisitionsmodul genannt. Nach beendeter Messung ist der k-Raum vollständig abgetastet. Der Hf-Puls ($\alpha$) dient zur Anregung einer gewählten Schicht bzw. Schichtdicke und kann die dem Fachmann für diesen Zweck üblicherweise bekannten Pulsformen annehmen. Diese sind beispielsweise Gauß- oder Sinc-Pulse. Die Pulsfolgen für die beiden Möglichkeiten können aus Figur 2a und 2b entnommen werden. Die in den Figuren 2a, 2b dargestellten Klammern schematisieren die Anwendung der innerhalb der Klammer (Akquisitionsmodul) befindlichen Abfolge auf Schichten bzw. Zeit-Punkte. Figur 2b bezieht sich dabei auf das Akquisitionsschema, bei dem nach jedem HF-Puls ($\alpha$) drei k-Raum-Zeilen gemessen werden. Figur 2a beschreibt den Akquisitionsfall für eine k-Raum-Zeile pro HF-Puls ($\alpha$). Parallel zu diesen Hf-Pulsen erfolgt die Bestimmung der interessierten Schicht infolge des Schichtselektionsgradienten Gz (Gs). Im Anschluß daran erfolgt die Rephasierung der Voxelmagnetisierungen durch einen Schichtselektionsgradienten umgekehrten Vorzeichens. Während der Rephasierung wird ein Gradient Gx (Gr) geschaltet, der die Voxelmagnetisierungen dephasiert und dadurch eine Kodierung im k-Raum vornimmt. Gleichzeitig wird ein Gradient Gy (Gp) geschaltet, um die Voxelmagnetisierung zur dephasieren und hierdurch wiederum eine k-Raum Kodierung durchzuführen. Die Dephasierung in x-Richtung wird wiederum mit Hilfe eines nachgeschalteten Gx-Gradienten umgekehrten Vorzeichens ausgeglichen. Gleichzeitig zu diesem rephasierend wirkenden Gradienten Gx erfolgt die Datenakquisition. Die Flächen unterhalb der Gradienten werden so bestimmt, daß das Gradientenecho in der Mitte des Akquisitionsfensters erscheint (Fig.2a). Aber auch andere Akquisitionsschemata sind denkbar, zum Beispiel asymmetrisches Gradientenecho. Somit ist eine Zeile des k-Raumes gemessen worden. Die obigen Schritte werden so oft wiederholt, wie Schichten bzw. Zeitpunkte zu messen sind. Hiernach wird der Inversionspuls (180°-Puls) bzw. die Kombination aus 90°- und Inversionspuls erneut appliziert. Der Vorgang wiederholt sich, wobei jedoch die jeweils nächste k-Raumzeile für alle Schichten gemessen wird. Die Zahl an Wiederholungen ergibt sich aus der Zahl der Phasenkodierschritte. Figur 1 zeigt den prinzipiellen Relaxationsverlauf der Longitudinalmagnetisierung und die hierbei erfindungsgemäß akquirierten Datenblöcke. Innerhalb der Datenblöcke - Zeitpunkte - werden die k-Raumzeile(n) für n Schichten gemessen. Die Messung ist dann beendet, wenn die k-Räume für die Schichten bzw. Zeitpunkte vollständig abgetastet wurden.

Auf diese Weise nutzt man erfindungsgemäß die Zeitspanne für eine komplette longitudinale Relaxation zur Datengewinnung über mehrere Schichten und mehrere Zeitpunkte möglichst effektiv aus. Somit können in einer vorgegebenen Zeit mehr Daten akquiriert werden. Unter Daten im Sinne der Erfindung ist die Informationsgewinnung von mehreren Schichten und mehreren unterschiedlichen Zeitpunkten zu verstehen.

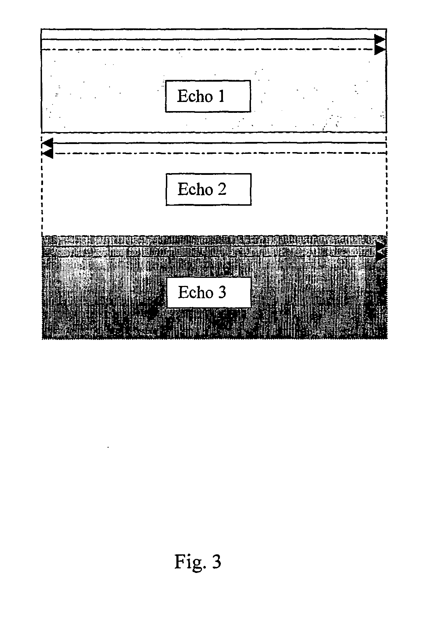

Um die Datenakquisition effizienter zu gestalten, können aufeinanderfolgend -nach schichselektiver Anregung durch den Hf-Puls($\alpha$)- mehrere k-Raumzeilen für jeweils eine Schicht gemessen werden. Dieses Verfahren wird auch mit dem Begriff Segmentierung bezeichnet. Die hier dargestellte Variante des Verfahrens beschreibt die logische Grenze der Segmentierung, da pro Segment nur eine k-Raumzeile akquiriert wird. Die Datenakquisition kann mehrere Segmente, wie beispielsweise 5 oder 7 beinhalten. Im hier beschriebenen Verfahren werden 3 k-Raumzeilen - jeweils eine Zeile pro Segment - aufeinanderfolgend akquiriert. Dies geschieht, indem das Vorzeichen des Gradienten Gx nach der Datenakquisition der vorhergehenden k-Raumzeile umgekehrt wird. Zuvor wird die entsprechende k-Raumzeile durch den Phasenkodiergradienten Gy kodiert (Figur 3).

Zusammenfassend seien die vier beschriebenen Pulssequenzen anhand eines Ablaufschemas beschrieben:

```
(a) 180°-[(α-Gradientenecho-Messung einer k-Raumzeile)

x Schichten x Zeitpunkte]
```

```
(b) 180°-[(α-Gradientenecho-Messung mehrerer k-
Raumzeilen) x Schichten x Zeitpunkte]


(c) 90°/180°-[(α-Gradientenecho-Messung einer k-
Raumzeile) x Schichten x Zeitpunkte]


(d) 90°/180°-[(α-Gradientenecho-Messung mehrerer k-
Raumzeilen) x Schichten x Zeitpunkte]
```

Um nach der Datengewinnung eine Fourier-Transformation anwenden zu können, müssen die zuvor gewonnenen Daten umsortiert werden. Dies geschieht in der Art und Weise, daß jeweils vollständige Datensätze (k-Räume) der zugehörigen Schichten zu unterschiedlichen Zeitpunkten resultieren. Dieses umsortieren findet vor der eigentlichen Rekonstruktion nach abgeschlossener Messung statt. Das Umsortierverfahren für die Sequenztypen basierend auf dem Schema der Messung einer k-Raumzeile pro Hf-Puls (α), ist unterschiedlich zu dem der Messung mehrerer k-Raumzeilen pro Hf-Puls (α). Bei den Sequenzen, die nur eine k-Raumzeile pro Hf-Puls (α) aquirieren, ist lediglich die chronologische, durch die Pulssequenz bestimmte Datenfolge im Meßspeicher entsprechend der k-Raum Definition umzusortieren. Bei den Sequenztypen, die mehrere k-Raumzeilen pro Hf-Puls (α) messen, müssen zusätzlich die Daten so umsortiert werden, daß jede Zeile eines k-Raumes das selbe Vorzeichen hat.

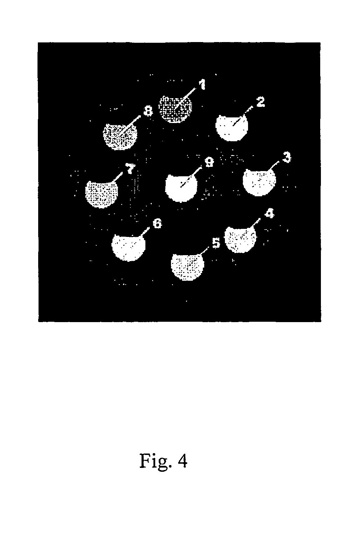

Figur 4 zeigt die rekonstruierte Relaxationskarte eines Phantoms. Innerhalb des Phantoms befinden sich neun einzelne Röhren. Acht dieser Röhren sind mit jeweils unterschiedlichen Konzentrationen an Gd-DTPA gefüllt, was deutlich durch die unterschiedliche Grauwerte zu erkennen ist. Die Messung wurde mit einem erfindungsgemäßen Verfahren vorgenommen, bei dem nach dem 180°-Puls jeweils eine k-Raumzeile pro Hf-Puls α aufgenommen wird.

Das erfindungsgemäße Bildgebungsverfahren, der Kernspintomograph sowie die Pulsfolge ermöglichen zum Beispiel die Akquisition von 20 Schichten zu 16 unterschiedlichen Zeitpunkten für eine Matrixgröße von 256 x 256 in einer Meßzeit von 8 min 28 sec zur Bestimmung der longitudinalen Relaxationszeit. Die Anzahl der Schichten, die Matrixgröße sowie die Anzahl der gemessenen Zeitpunkte können natürlich variieren. Die Genauigkeit des hier beschrieben Verfahrens im Vergleich zum standardisierten Spektroskopieverfahren ist größer als 95%, hat zudem aber den wesentlichen Vorteil, Datensätze mehrere Schichten und Zeitpunkte in einem deutlich kürzeren Meßintervall bzw. überhaupt zu messen.

Der erfindungsgemäße Kernspintomograph ist mit Mitteln ausgestattet, welche die Erzeugung der erfindungsgemäßen Pulssequenz ermöglichen. Unter Mitteln zur Erzeugung der erfindungsgemäßen Pulssequenz ist ein Datenträger zu verstehen, welcher die zur Aussendung der erfindungsgemäßen Pulssequenz notwendigen Informationen speichert und an eine Hochfrequenzeinheit zur Bereitstellung der Hf-Pulse abgibt. Zur Erzeugung der erfindungsgemäßen Pulssequenz werden weiterhin Spulen zur Erzeugung des statischen Grundfeldes, Spulen zur Generierung der zeitlich veränderbaren Magnetfelder (Gradienten) sowie ein Rechner zur Ansteuerung aller systembedingten Komponenten eingesetzt. Weiterhin ist der erfindungsgemäße Kernspintomograph mit einer Auswerteelektronik ausgerüstet, welche die Meßdaten erfindungsgemäß umsortiert.

Beispiel:

Phantommessung mit 90°/180° drei k-Raumzeilensequenz. $T_R$ (= Repetitionszeit) = 13 msec; TI (= Inversionszeit) = 30 msec; TD (= Verzögderungszeit) = 3 sec; α (= Flipwinkel) = 6°; 4 Schichten; Schichtdicke = 8 mm ; Matrixgröße = 256; FOV (= Darstellungsbereich) = 250 mm; 48 Zeitpunkte.

**Patentansprüche**

1. Pulssequenz zur Messung der $T_1$ Relaxationszeit mit kernmagnetischer Resonanztomographie, umfassend einen 180°-Puls oder einen 180°-Puls und einem dem 180°-Puls vor gelagerten 90°-Puls sowie ein Akquisitionsmodul, bestehend aus einem α Hochfrequenzpuls zur Datengewinnung und einer Gradientenfolge zur Schichtselektion, k-Raum Zeilenkodierung und Datenakquisition, das für mindestens zwei Schichten und zwei Zeitpunkte durchgeführt wird,

**dadurch gekennzeichnet, dass**

dem 180°-Puls ein Gradientenspoiling zur Erreichung der transversalen Magnetisierung von null nachgeschaltet wird.

2. Pulssequenz nach Anspruch 1,
**dadurch gekennzeichnet,**
**dass** in dem Akquisitionsmodul nach Anspruch 1 in Ausleserichtung mindestens zwei aufeinander folgende Gradienten G(r) in alternierend umgekehrten Vorzeichen angelegt sind.

3. Pulssequenz nach Anspruch 2,
**dadurch gekennzeichnet,**
**dass** während des Anlegens der aufeinander folgenden Gradientenfelder Daten ausgelesen werden.

4. NMR-Bildgebungsverfahren, bei dem durch Einstrahlen von Hochfrequenzpulsen und Anlegen von wenigstens einem magnetischen Gradientenfeld wenigstens ein Schicht- oder Volumenbereich selektiert wird, in dem eine kernmagnetische Resonanz angelegt und das Messsignal ermittelt wird,
**dadurch gekennzeichnet,**
**dass** eine Pulssequenz nach einem der Ansprüche 1 bis 3 eingesetzt wird.

5. NMR-Bildgebungsverfahren nach Anspruch 4,
**dadurch gekennzeichnet,**
**dass** die gemessenen Daten zum Einsatz der Fourier-transformation umsortiert werden.

6. Kernmagnetischer Resonanztomograph mit Mitteln zur Erzeugung von Pulssequenzen,
**dadurch gekennzeichnet,**
**dass** die Mittel zur Erzeugung von Pulssequenzen eine Pulssequenz nach einem der Ansprüche 1 bis 3 erzeugen.

**Claims**

1. Pulse train for measuring $T_1$ relaxation time with nuclear magnetic resonance tomography, comprising a 180° pulse, or a 180° pulse and a 90° pulse preceding the 180° pulse, as well an acquisition module consisting of an $\alpha$-high frequency pulse for data acquisition and a gradient sequence for slice the selection, k-space line coding and data acquisition which is carried out for at least two slices and two points in time, **characterised in that** a spoiler gradient is applied after the 180° pulse in order to obtain transverse magnetisation of zero.

2. Pulse train according to Claim 1, **characterised in that**, in the acquisition module according to Claim 1, at least two successive gradients G(r) with alternately reversed signs are applied in the selection direction.

3. Pulse train according to Claim 2, **characterised in that** data is read out during the application of the successive gradient fields.

4. NMR imaging method in which, by irradiation of high-frequency pulses and application of at least one magnetic gradient field, at least one slice or volume region is selected in which a nuclear magnetic resonance is applied and the measuring signal is determined, **characterised in that** a pulse train according to any one of Claims 1 to 3 is used.

5. NMR imaging method according to Claim 4, **characterised in that** the measured data is sorted for use of the Fourier transformation.

6. Nuclear magnetic resonance tomograph with means for generating pulse trains, **characterised in that** the means for generating pulse trains generate a pulse train according to any one of Claims 1 to 3.

**Revendications**

1. Train d'impulsions destiné à la mesure du temps de relaxation $T_1$ avec tomographie par résonance magnétique nucléaire, comprenant une impulsion de 180° ou une impulsion de 180° et une impulsion de 90° précédant l'impulsion de 180°, ainsi qu'un module d'acquisition, se composant d'une impulsion haute fréquence $\alpha$ destinée à l'acquisition de données et d'une série de gradients en vue de la sélection de couche, du codage en ligne de l'espace k et de l'acquisition de données, qui est effectué pour au moins deux couches et deux instants,
**caractérisé en ce que**
un spoiling de gradients est placé après l'impulsion de 180° en vue de l'atteinte de l'aimantation transversale nulle.

2. Train d'impulsions selon la revendication 1,
**caractérisé en ce**
**qu'**au moins deux gradients successifs G(r) sont appliqués en signe inverse alterné dans le module d'acquisition selon la revendication 1 dans le sens de lecture.

3. Train d'impulsions selon la revendication 2,
**caractérisé en ce**
**que** des données sont lues au cours de l'application des champs de gradients successifs.

4. Procédé d'imagerie par résonance magnétique nucléaire, dans le cas duquel au moins une zone de couche ou de volume est sélectionnée via irradiation d'impulsions haute fréquence et définition d'au moins un champ de gradients magnétique, dans laquelle une résonance magnétique nucléaire est appliquée et le signal de mesure est déterminé,
**caractérisé en ce**
**qu'**un train d'impulsions est mis en oeuvre selon l'une quelconque des revendications 1 à 3.

5. Procédé d'imagerie par résonance magnétique nucléaire selon la revendication 4,
**caractérisé en ce**
**que** les données mesurées sont triées en vue de la mise en oeuvre de la transformation de Fourier.

6. Tomographie par résonance magnétique nucléaire avec des moyens destinés à la génération de trains d'impulsions,
**caractérisée en ce**
**que** les moyens destinés à la génération de trains d'impulsions génèrent un train d'impulsions selon l'une quelconque des revendications 1 à 3.

Fig. 1

Fig. 2a

Fig. 2b

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0357100 A2
- WO 9301509 A

**In der Beschreibung aufgeführte Nicht-Patentliteratur**

- **R.J. ORDIDGE et al.** Inversion-Recovery (Inversion - Relaxations) EPI (Echo-Planare Bildgebung) Methode. *Magnetic Resonance in Medicine,* 1990, vol. 16, 238-245
- **DEICHMANN et al.** *Journal of Magnetic Resonance,* 1992, vol. 96, 608-612
- **BLÜML.** *MRM,* 1993, vol. 30, 289-295
- **DEICHMANN.** *Magnetic Resonance in Medicine,* 1999, vol. 42, 206-209
- *The Review of Scientific Instruments,* 1970, vol. 41 (2), 250-251
- **DEICHMANN.** snapshot FLASH. *Journal of Magnetic Resonance,* 1992, vol. 96, 608-612